# EUROPEAN PATENT APPLICATION

(11) **EP 4 557 369 A1**
(43) Date of publication of application: **21.05.2025**
(21) Application number: 23210880.3
(22) Date of filing: 20.11.2023
(51) Int. Cl.: H01L 27/02, H02H 9/04

(54) **TRANSIENT VOLTAGE SUPPRESSOR CIRCUIT**

(71) Applicant: Infineon Technologies AG, 85579 Neubiberg (DE)
(72) Inventor: TYLAITE, Egle, 81549 München (DE); WILLEMEN, Joost, 81929 München (DE); VENDT, Vadim Valentinovic, 85521 Ottobrunn (DE)
(74) Representative: Müller Hoffmann & Partner

(57) **Abstract**

A transient voltage suppressor, TVS, circuit (100) is proposed. The TVS circuit (100) includes a semiconductor substrate (102) comprising a first TVS device (1041) and a second TVS device (1042) electrically connected in series. The TVS circuit further includes a resistor (106). The resistor (106) and at least one of the first TVS device (1042) or the second TVS device (1043) are electrically connected in parallel.

## Description

### TECHNICAL FIELD

The present disclosure relates to a transient voltage suppressor, TVS, circuit, in particular to a TVS circuit including a first TVS device and a second TVS device electrically connected in series.

### BACKGROUND

ESD protection devices are used to protect electronic circuit blocks of an integrated circuit from electrostatic discharge pulses or other current pulses that can occur during the manufacture of the integrated circuit, e.g. back-end processing, or during its operation. Examples of such pulses are HBM (HBM: Human Body Model) pulses according to DIN IEC 60749-26, MM (MM: Machine Model) pulses according to DIN IEC 60749-27, or CDM (CDM: Charged Device Model) pulses according to DIN IEC 60749-28, or pulses defined in Electrostatic discharge immunity test according to DIN IEC 61000-4-2. When omitting ESD protection devices, there is a risk of destruction of useful components of the circuit blocks to be protected, e.g. due to current or voltage overload, which can lead, inter alia, to short circuits, an increase in leakage currents or defective gate oxides. This can result in a loss of functionality of the integrated circuit.

ESD protection devices face increasingly challenging requirements with respect to, for example, electrical specifications, cost and development timeline. Improved protection concepts are needed to meet these requirements.

### SUMMARY

An example of the present disclosure relates to a transient voltage suppressor, TVS, circuit. The TVS circuit includes a semiconductor substrate comprising a first TVS device and a second TVS device electrically connected in series. The TVS circuit further includes a resistor. The resistor and at least one of the first TVS device or the second TVS device are electrically connected in parallel.

Another example of the present disclosure relates to a method of manufacturing a TVS circuit. The method includes forming a first TVS device and a second TVS device in a semiconductor substrate. The method further includes electrically connecting the first TVS device and the second TVS device in series. The method further includes providing a resistor. The resistor and at least one of the first TVS device or the second TVS device are electrically connected in parallel.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of ESD protection devices and together with the description serve to explain principles of the examples. Further examples are described in the following detailed description and the claims.
Figs. 1A and 1B are simplified circuit diagrams depicting exemplary circuit configurations of TVS circuits.
Figs. 2A and 2B are simplified circuit diagrams and corresponding exemplary cross-sections for illustrating circuit configurations of TVS circuits.
Figs. 3A, 3B and 3C are simplified circuit diagrams depicting exemplary circuit configurations of TVS circuits connected antiparallel.
Figs. 4A and 4B are simplified circuit diagrams depicting exemplary circuit configurations of TVS circuits connected in series.

### DETAILED DESCRIPTION

In the following detailed description, reference is made to the accompanying drawings, which form a part hereof and in which are shown by way of illustrations specific examples in which TVS circuits may be formed. It is to be understood that other examples may be utilized and structural or logical changes may be made without departing from the scope of the present disclosure. For example, features illustrated or described for one example can be used on or in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" may describe a permanent low-resistive connection between electrically connected elements, for example a direct contact between the concerned elements or a low-resistive connection via a metal and/or heavily doped semiconductor material. The term "electrically coupled" may include that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact may be a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of the present disclosure relates to a transient voltage suppressor, TVS, circuit. TVS circuits are known in the art and are typically used for protecting integrated circuits, e.g. semiconductor chips, from damage caused by an overvoltage imposed on the integrated circuit. An integrated circuit is designed for operating under conditions specified in the data sheet of the integrated circuit. However, situations may occur where the integrated circuit is exposed to an ESD event, or to fast electrical transient pulses. This may lead to an unexpected high voltage beyond the absolute maximum ratings of the integrated circuit. The TVS circuit is configured to protect circuit blocks of the integrated circuit for avoiding damages, e.g. short circuits or increase in leakage currents, that are likely to occur to the integrated circuit when a stress condition is imposed to the integrated circuit that would lead to an overvoltage if there were no TVS circuit connected. In other words, the TVS circuit acts as a voltage clamping device to avoid excessive and damaging overvoltage at stress exposed IC pins.

The TVS circuit may include a semiconductor substrate comprising a first TVS device and a second TVS device electrically connected in series. The TVS circuit may further include a resistor. The resistor and at least one of the first TVS device or the second TVS device may be electrically connected in parallel.

For example, the semiconductor substrate may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). For example, the semiconductor substrate may be formed of a base substrate, e.g. wafer, having none, one or even more semiconductor layers such as epitaxial semiconductor layers on the base substrate. The semiconductor substrate may be a Czochralski (CZ), e.g. a magnetic Czochralski, MCZ, or a float zone (FZ), or an epitaxially deposited silicon semiconductor substrate.

The first TVS device may be or may include a TVS pn- or pin-diode as a protection element. TVS pn- or pin-diodes are easy to use and have a simple diode-like current-voltage (I-V) behavior that may allow for good protection performance, low voltage overshoot and fast turn-on. For example, TVS pn- or pin-diodes may be used for fast turn-on applications, multipurpose and low speed applications, e.g. switches or audio applications. When using npn- or pnp-based TVS devices, the npn or pnp transistors are typically shorted with respect to emitter and base or are configured with an open (floating) base. In case of an overvoltage event, the collector-to-base pn-junction may be forced into an electric breakdown, e.g. avalanche breakdown. The resulting breakdown current, e.g. an avalanche current, flowing to the base contact causes an ohmic voltage drop along the base region. With increasing breakdown current, this voltage drop may forward-bias the emitter-to-base pn-junction or - in the case of a floating base region - all breakdown current is forward biasing the base-emitter junction. This results in an avalanche-triggered turning-on of the npn- or pnp-based TVS device. The npnor pnp-based TVS devices typically have a small or mild snapback in the I-V behavior caused by the triggering of the device. Bipolar-based TVS devices, e.g. npn or pnp transistors with shorted or floating base, may allow for an improved protection performance and enable a low line capacitance which is beneficial for high speed/RF applications. Bipolar based TVS devices may be used for similar applications as diode-like TVS protection concepts including high speed I/O and RF applications, for example. For example, TVS silicon controlled rectifier, TVS SCR (TVS thyristor) devices may allow for another improvement in the protection performance caused by a further reduction of the clamping voltage due to a strong snapback behavior of the device. This type of device is thus best suited for RF applications, or applications with most demanding requirements on the clamping voltage, e.g. high speed applications, low voltage differential signaling, super fine geometry SoC I/O with nm-scale technology, for example. An example of an application is the placement of the TVS circuit near a connection port, for example an USB-C receptacle, in a configuration as an ESD protection circuit, where one of more of the data lines, which connect receptacle pins to other circuit elements in the application, are protected by placing one or more TVS circuits between each data line and the ground connection. For example, this application can operate with low voltage differential signals, with pulse amplitudes typically between 100 mV and 1 V, with a differential line impedance typically of 90 to 110 Ohm and with a signal bandwidth typically ranging from 1 to 100 GHz.

The first TVS device may be a single protection element, e.g. a pn- or pin diode, or a bipolar based TVS protection element, or a SCR. In some other examples, the first TVS device may be based on a plurality of interconnected protection elements, e.g. an interconnection of protection elements as described above. For example, in case of diode or SCR protection elements, the protection elements may be serially connected to one another, e.g. with their anodes or with their cathodes (so-called anti-serial connection), or may be connected anode to cathode. For npn- or pnp-based protection elements, the protection elements may be connected collector to collector, or emitter to emitter, or emitter to collector. The protection elements may also be connected in parallel. For example, the interconnection of protection elements of the first TVS device may also be a combination of a series and parallel connection. For example, the TVS device may also include one or more trigger structures, e.g. Zener diodes, for providing a trigger current, e.g. SCR trigger current, for a protection element of the first TVS device in case of an overvoltage event. Also bypass elements, e.g. elements providing a parallel conduction path to a device that can only be operated as a TVS device in one polarity, may be part of the first TVS device, for example.

The details described above likewise apply to the second TVS device.

The resistor provides for a resistive current path parallel to at least some of the TVS devices in the semiconductor substrate, e.g. chip. Thus, multiple TVS devices are placed in series within a single chip, i.e. within the semiconductor substrate, without electrically isolating them from each other by device isolation structures such as, for example, trench isolation structures or pn-junction isolation structures or buried oxide isolation structures. When the parallel path is designed to be highly resistive, it is not a preferred path for high frequency signals, so in effect at high frequencies the series connection of the TVS devices in the semiconductor substrate may operate as if separate TVS devices, e.g. in different chips, were completely electrically isolated. The highly resistive parallel path across one or more of the multiple TVS devices may have a significantly higher impedance than the characteristic impedance of the signal line that is protected by the TVS device. As the parallel path resistance is much higher than the characteristic impedance of the line the signal transmission over the line will not be affected by the added high shunt resistance.

The TVS circuit of the present disclosure provides benefits with respect to cost and performance. A simple package, e.g. CSP (Chip Scale Package), may be used as a cost effective packaging option (compared to plastic molded packages) and there are less lithography layers needed, e.g. no need for isolation trenches, buried layers, etc., or other process steps like epitaxial semiconductor layers. This may allow for a substantial cost reduction. Moreover, the performance with respect to capacitance and harmonics may be improved compared to similar, but electrically isolated, multi-serial TVS devices. Where multi-serial means, e.g. multiple, N, TVS devices are connected in series with one another, the working voltage and resistance is N times higher, and the overall capacitance is N times lower, for example. In addition, the TVS circuit of the present disclosure may have a characteristic frequency dependent behavior. For DC or low frequency signals, the TVS circuit may behave like a resistor and/or single TVS device. While for high frequencies the TVS circuit may have the benefits of multi-serial TVS devices. At which frequency the TVS circuit starts to behave like multi-serial TVS devices (the resistive bypass path no longer plays a role) may depend mainly on the impedance of the TVS device and the resistance of the bypass path, i.e. the resistance of the resistor. As an illustrative non-limiting numeric example, a TVS device for high frequency applications may be defined by a resistance of approximately 1 Ω and a capacitance of approximately 0.2 pF, which results in an impedance of 800 Ω at a frequency of 1 GHz. When the resistive bypass path, i.e. the resistor, has a much higher impedance, e.g. a resistance in the range from 2 kΩ to 5 kΩ, then for frequencies larger than 1 GHz the TVS circuit behaves like multi-serial TVS devices. TVS devices of technologies based on high resistive substrates may have resistive paths, i.e. resistances of the bypass resistor in the range of several tens of kΩ, which may be large enough for high frequency applications, e.g. antenna or USB4. For example, the present disclosure may be beneficial for applications where capacitance and harmonics are more critical than high resistivity in the off-state or low leakage current in the off-state, e.g. high speed data line protection, antenna protection, etc. Moreover, the TVS circuit of the present disclosure may be beneficial for applications that require an increased working voltage, e.g. high voltage antenna protection. By stacking multiple TVS devices in the TVS circuit, capacitance and harmonics may be lowered compared with a higher voltage single TVS device. For example, for USB4 protection, a desired working voltage, e.g. 1 V, may be designed by combining two pin diode protection elements in series (forward voltage of each approximately 0.7 V) in combination with resistive bypass. This may allow for a better clamping voltage than alternative solutions, e.g. a snapback thyristor.

For example, the TVS circuit may be a discrete device. A discrete device is an elementary electronic device constructed as a single unit in a single die or single semiconductor chip or substrate. Thus, no functional units other than those required for the TVS functionality may be included in the single die or semiconductor chip or substrate. For example, the discrete device may be a two terminal device.

For example, the semiconductor substrate may include the resistor. The resistor of the TVS circuit may be a resistive current path formed by a continuously p-doped or n-doped part of the semiconductor substrate. The continuously p-doped or n-doped part of the semiconductor substrate may include, along the resistive current path, a plurality of pairs of p-doped semiconductor regions adjoining or overlapping with one another. For example, a p-doped (or n-doped) part of the first TVS device may overlap with a p-doped (or n-doped) part of the semiconductor substrate. This p-doped (or n-doped) part of the semiconductor substrate may overlap, at another position in the semiconductor substrate, with a p-doped (or n-doped) part of the second TVS device. In addition or as an alternative to implementing at least part of the resistor by the semiconductor substrate, the resistor may also be formed by using the sheet resistance of doped regions in the semiconductor substrate, e.g. source or drain regions, or emitter or collector or base regions, or cathode or anode regions. In addition or as an alternative to the above examples, the resistor may also be formed in a wiring area over the semiconductor substrate. The wiring area may include one or more than one, e.g. two, three, four or even more wiring levels. Each wiring level may be formed by a single one or a stack of conductive layers, e.g. metal layer(s) or highly doped semiconductor layers such as highly doped polycrystalline silicon. For example, the wiring levels may include at least one of Cu, Au, AlCu, Ag, or alloys thereof. The wiring levels may be lithographically patterned, for example. The wiring area may also include a higher resistive level for resistor formation, e.g. a highly resistive polycrystalline layer. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The resistor may be formed by one or more elements of the wiring area over the semiconductor substrate. For example, the resistor may be formed in one or more of the wiring levels, or by using the wiring level forming a gate electrode by polycrystalline silicon. The resistor may be electrically connected to semiconductor regions of the first and/or second TVS devices by further conductive structures in the wiring area, e.g. contact plugs or lines or vias.

For example, the resistive current path may include a part of the semiconductor substrate in an active area of the at least one of the first TVS device or the second TVS device. The resistive current path may include part of the semiconductor substrate arranged between semiconductor regions of the first and/or second TVS device.

For example, the semiconductor substrate may further include a third TVS device and a fourth TVS device electrically connected in series. The TVS circuit may further include a second resistor. The second resistor and at least one of the third TVS device or the fourth TVS device may be electrically connected in parallel. Exemplary details described above with respect to the first TVS device likewise apply to the third and fourth TVS devices. For example, the third TVS device and the fourth TVS device may be electrically connected anti-parallel (i.e. in parallel and with opposite device polarity) to the serial connection of the first TVS device and the second TVS device. This may allow for setting up bidirectional ESD protection, for example.

For example, cross-section designs of the first TVS device and the third TVS device may correspond to each other.

For example, the first TVS device may include a first TVS pn- or pin-diode, or a first npn- or pnp-based TVS protection element, or a first TVS SCR, and the second TVS device may include a second TVS pn- or pin-diode, or a second npn- or pnp-based TVS protection element, or a second TVS SCR. An n-doped region of the first TVS device and a p-doped region of the second TVS device may be electrically connected via a wiring area over the semiconductor substrate. The resistor may be a resistive current path through a p-doped part of the semiconductor substrate between a p-doped region of the first TVS device and the p-doped region of the second TVS device. For example, the n-doped region of the first TVS device may be a cathode region of a diode-based or SCR-based protection element of the first TVS device, and the p-doped region of the first TVS device may be an anode region of a diode-based or SCR-based protection element of the first TVS device. Likewise, the n-doped region of the second TVS device may be a cathode region of a diode-based or SCR-based protection element of the second TVS device, and the p-doped region of the second TVS device may be an anode region of a diode-based or SCR-based protection element of the second TVS device. In some other examples, the n-doped region of the first TVS device may be a collector region of an npn-based TVS protection element of the first TVS device, and the p-doped region of the first TVS device may be a base region of an npn-based TVS protection element of the first TVS device. Likewise, the n-doped region of the second TVS device may be a collector region of an npn-based TVS protection element of the second TVS device, and the p-doped region of the second TVS device may be a base region of an npn-based TVS protection element of the second TVS device. In case of npn-based TVS protection elements with floating base, an n-doped region of the first npn-based TVS protection element and an n-doped region of the second npn-based TVS protection element may be electrically connected via a wiring area over the semiconductor substrate. In case of pnp-based TVS protection elements, a p-doped region of the first pnp-based TVS protection element and a p-doped region of the second pnp-based TVS protection element may be electrically connected via a wiring area over the semiconductor substrate.

For example, the third TVS device may include a third TVS pn- or pin-diode, or a third npn- or pnp-based TVS, or a third TVS SCR, and the fourth TVS device may include a fourth TVS pnor pin-diode, or a fourth npn- or pnp-based TVS, or a fourth TVS SCR. An n-doped region of the third TVS device and a p-doped region of the fourth TVS device may be electrically connected via a wiring area over the semiconductor substrate. The second resistor may be a resistive current path through a p-doped part of the semiconductor substrate between a p-doped region of the third TVS device and the p-doped region of the fourth TVS device. The exemplary configurations of the n- and p-doped region of the first TVS device described above likewise apply to the n- and p-doped region of the third TVS device. The exemplary configurations of the n- and p-doped region of the second TVS device described above likewise apply to the n- and p-doped region of the fourth TVS device.

For example, the TVS circuit may further include a third resistor being a resistive current path through a p-doped part of the semiconductor substrate between the p-doped region of the first TVS device and the p-doped region of the third TVS device. Exemplary configurations for the p-doped region of the first TVS device and the p-doped region of the third TVS device are given above.

For example, the first TVS device may include a first TVS pn- or pin-diode, or a first npn- or pnp-based TVS protection element, or a first TVS SCR. The second TVS device may include a second TVS pn- or pin-diode, or a second npn- or pnp-based TVS protection element, or a second TVS SCR. A p-doped region of the first TVS device and an n-doped region of the second TVS device may be electrically connected via a wiring area over the semiconductor substrate. The resistor may be a resistive current path through an n-doped part of the semiconductor substrate between an n-doped region of the first TVS device and the n-doped region of the second TVS device. The above exemplary configurations of the p-doped region and the n-doped region of the first and second TVS device likewise apply.

For example, the third TVS device may include a third TVS pn- or pin-diode, or a third npn- or pnp-based TVS protection element, or a third TVS SCR. The fourth TVS device may include a fourth TVS pn- or pin-diode, or a fourth npn- or pnp-based TVS protection element, or a fourth TVS SCR. A p-doped region of the third TVS device and an n-doped region of the fourth TVS device may be electrically connected via a wiring area over the semiconductor substrate. The second resistor may be a resistive current path through an n-doped part of the semiconductor substrate between an n-doped region of the third TVS device and the n-doped region of the fourth TVS device. The above exemplary configurations of the p-doped region and the n-doped region of the third and fourth TVS device likewise apply.

For example, the TVS circuit may further include a third resistor being a resistive current path through an n-doped part of the semiconductor substrate between the n-doped region of the first TVS device and the n-doped region of the third TVS device.

For example, the n-doped region of the second TVS device and the p-doped region of the third TVS pn- or pin-diode may be electrically connected. The p-doped region of the first TVS device and the n-doped region of the fourth TVS device may be electrically connected. Exemplary configurations for the TVS devices and the p- and n-doped regions are given above.

For example, the p-doped region of the second TVS device and the n-doped region of the third TVS device may be electrically connected. The n-doped region of the first TVS device and the p-doped region of the fourth TVS device may be electrically connected. Exemplary configurations for the TVS devices and the p- and n-doped regions are given above.

For example, the TVS circuit as described in any or any combination of examples herein may be included in an application circuit or system between a data line and a reference line such as, for example, a ground (GND) line.

Details with respect to structure, or function, or technical benefit of features described above with respect to a TVS circuit likewise apply to the exemplary methods described herein. Processing the semiconductor substrate may comprise one or more optional additional features corresponding to one or more aspects mentioned in connection with the proposed concept or one or more examples described above or below.

A method of manufacturing a transient voltage suppressor, TVS, circuit may include forming a first TVS device and a second TVS device in a semiconductor substrate. The method may further include electrically connecting the first TVS device and the second TVS device in series. The method may further include providing a resistor. The resistor and at least one of the first TVS device or the second TVS device may be electrically connected in parallel.

For example, the resistor may be provided as a resistive current path formed by a continuously p-doped or n-doped part of the semiconductor substrate.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded.

The examples and features described above and below may be combined. Functional and structural details (e.g. materials, dimensions) described with respect to the examples above shall likewise apply to the examples illustrated in the figures and described further below.

More details and aspects are mentioned in connection with the examples described above or below. Processing a semiconductor substrate, e.g. a wafer, may comprise one or more optional additional features corresponding to one or more aspects mentioned in connection with the proposed concept or one or more examples described above or below.

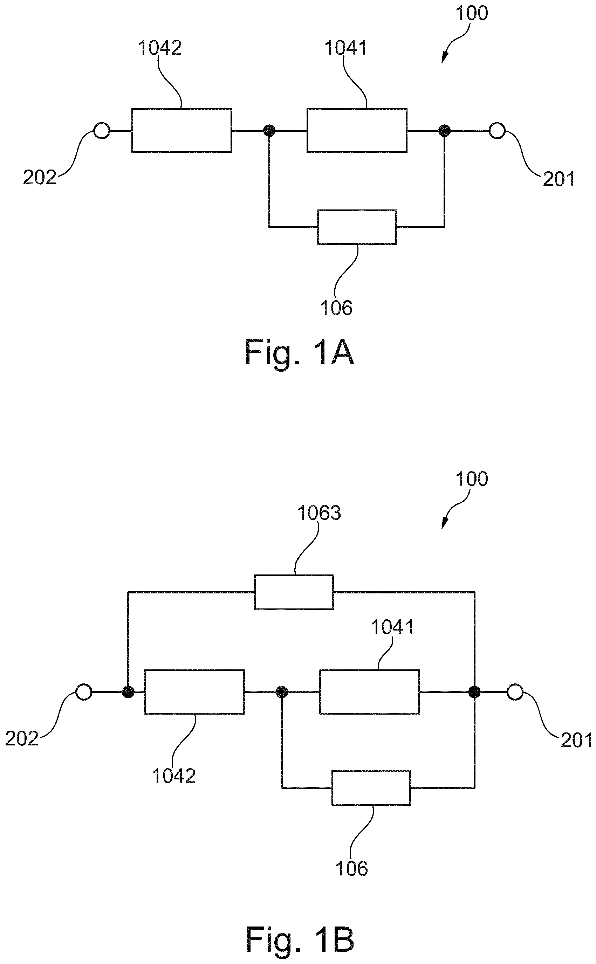

Fig. 1A illustrates a simplified circuit diagram depicting an exemplary circuit configuration of a TVS circuit 100. The TVS circuit 100 includes a serial interconnection of a first TVS device 1041 and a second TVS device 1042. One end of the serial interconnection of the first TVS device 1041 and the second TVS device 1042 is electrically coupled to a first node 201. The other end of the serial interconnection of the first TVS device 1041 and the second TVS device 1042 is electrically coupled to a second node 202. A resistor 106 and the first TVS device 1041 are electrically connected in parallel. For example, the first and/or second nodes 201, 202 may be pins of a discrete TVS device. In some examples, one or more TVS protection elements may be interconnected between the first node 201 and a first pin and/or between the second node 202 and a second pin of a chip package. While the TVS circuit may be a circuit arrangement of a plurality of TVS devices, each TVS device may include one or an interconnection of more than one TVS protections elements (e.g. diodes or bipolar based TVS protection elements or SCRs).

Fig. 1B illustrates a simplified circuit diagram depicting another exemplary circuit configuration of a TVS circuit 100. In addition to the circuit elements illustrated in Fig. 1A, the TVS circuit 100 depicted in Fig. 1B further includes a resistor 1063, wherein one end of the resistor 1063 is electrically connected to the first node 201, and the other end of the resistor 1063 is electrically connected to the second node 202.

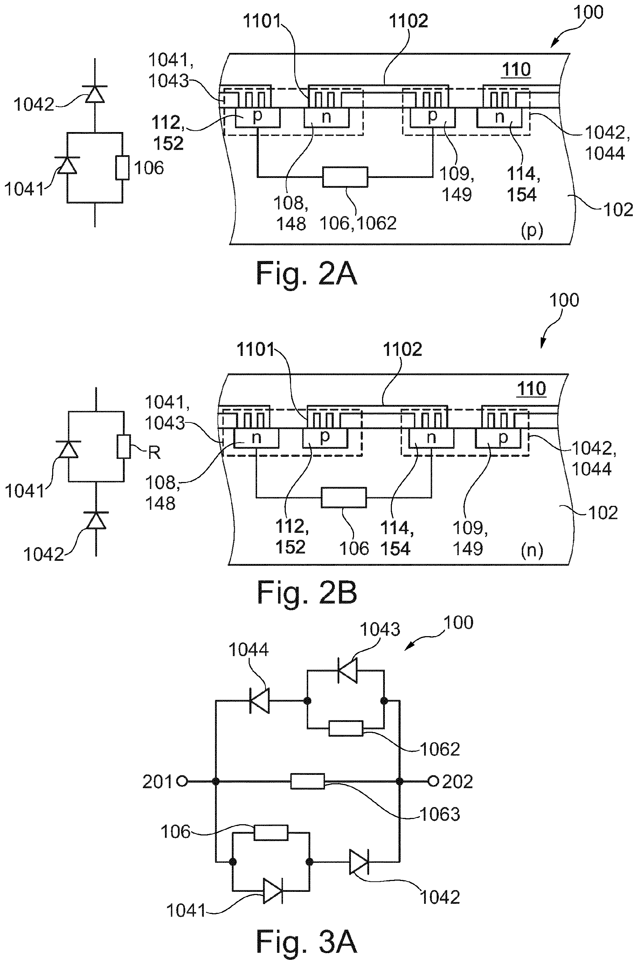

Fig. 2A illustrates a simplified circuit diagram depicting an exemplary circuit configuration and corresponding exemplary cross-section of a TVS circuit 100. For illustrative purposes, the TVS devices 1041, 1042 are exemplified by pn-junction diodes. Other protection elements, e.g. bipolar-based TVS protection elements or SCRs may also be used.

A cathode region 108 of the first TVS device 1041 and an anode region 109 of the second TVS device 1042 are electrically connected via a wiring area 110 over a semiconductor substrate 102. Circuit elements in the semiconductor substrate 102 may be interconnected via contact plugs 1101 and a wiring level 1102, e.g. metal layer, of the wiring area 110, for example.

A resistor 106 is electrically connected in parallel to the first TVS device 1041 and is implemented in the semiconductor substrate 102 as a resistive current path through a p-doped part of the semiconductor substrate 102 between an anode region 112 of the first TVS device 1041 and the p-doped region 109 of the second TVS device 1042. The first and second TVS devices may be arranged in parts of the semiconductor substrate that are not electrically isolated from each other by pn junctions (junction isolation), trenches filled with isolating material (trench isolation), buried oxides (silicon on oxide isolation) or combinations thereof.

Fig. 2B illustrates a simplified circuit diagram depicting another exemplary circuit configuration and corresponding exemplary cross-section of a TVS circuit 100. For illustrative purposes, the TVS devices 1041, 1042 are exemplified by pn-junction diodes. Other protection elements, e.g. bipolar-based TVS protection elements or SCRs may also be used.

The anode region 112 of the first TVS device 1041 and the cathode region 114 of the second TVS device are electrically connected via the wiring area 110 over the semiconductor substrate 102.

The resistor 106 is electrically connected to the first TVS device 1041 and is implemented in the semiconductor substrate 102 as a resistive current path through an n-doped part of the semiconductor substrate 102 between the cathode region 108 of the first TVS device 1041 and the cathode region 114 of the second TVS device 1042.

Fig. 3A illustrates a simplified circuit diagram depicting another exemplary circuit configuration of a TVS circuit 100.

The TVS circuit 100 depicted in Fig. 3A illustrates an antiparallel connection of the circuit illustrated in Fig. 2A. Thus, the TVS circuit 100 of Fig. 3A further includes a third TVS device 1043 and a fourth TVS device 1044. For illustrative purposes, the TVS devices 1043, 1044 are exemplified by pn-junction diodes. Other protection elements, e.g. bipolar based or SCR protection elements may also be used.

Further referring to Fig. 3A and to Fig. 2A, a cathode region 148 of the third TVS device 1043 and an anode region 149 of the fourth TVS device 1044 are electrically connected via the wiring area 110 over the semiconductor substrate 102. A second resistor 1062 is electrically connected in parallel to the third TVS device 1043 and is implemented in the semiconductor substrate 102 as a resistive current path through a p-doped part of the semiconductor substrate 102 between an anode region 152 of the third TVS device 1043 and the anode region 149 of the fourth TVS device 1044.

The TVS circuit 100 further includes a third resistor 1063 implemented in the semiconductor substrate 102 as a resistive current path through a p-doped part of the semiconductor substrate 102 between the anode region 112 of the first TVS device 1041 and the anode region 152 of the third TVS device 1043. Each of the first to third resistors 1061, 1062, 1063 may be formed in the same semiconductor substrate 102 and may thus be formed as distributed resistances, e.g. resistive paths inside the semiconductor substrate 102 electrically coupled between circuit nodes of the TVS circuit 100.

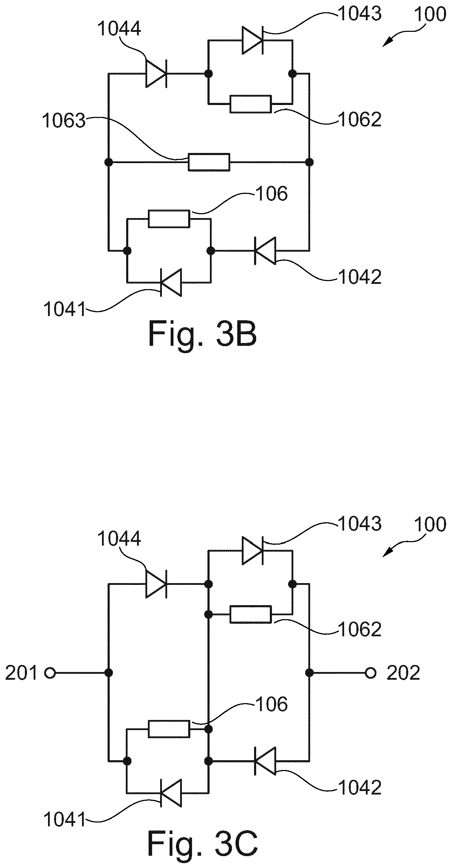

Fig. 3B illustrates a simplified circuit diagram depicting another exemplary circuit configuration of a TVS circuit 100.

The TVS circuit 100 depicted in Fig. 3B illustrates an antiparallel connection of the circuit illustrated in Fig. 2B. Thus, the TVS circuit 100 of Fig. 3B further includes the third TVS device 1043 and the fourth TVS device 1044. For illustrative purposes, the TVS devices 1043, 1044 are exemplified by pn-junction diodes. Other protection elements, e.g. bipolar based or SCR may also be used.

Further referring to Fig. 3B and also to Fig. 2B, the anode region 152 of the third TVS device 1043 and the cathode region 154 of the fourth TVS device 1044 are electrically connected via the wiring area 110 over the semiconductor substrate 102. The second resistor 1062 is electrically connected in parallel to the third TVS device 1043 and is implemented in the semiconductor substrate 102 as a resistive current path through an n-doped part of the semiconductor substrate 102 between the cathode region 148 of the third TVS device 1043 and the n-doped region 154 of the fourth TVS device 1044.

The TVS circuit 100 further includes a third resistor 1063 being a resistive current path through an n-doped part of the semiconductor substrate 102 between the cathode region 108 of the first TVS device 1041 and the cathode region 148 of the third TVS device 1043.

Another configuration example of a TVS circuit 100 is illustrated in Fig. 3C. The configuration example of Fig. 3C differs from the configuration example illustrated in Fig. 3A by replacing the resistive path from node 201 to node 202 via the third resistor 1063 by an electric connection between the cathode region 108 of the first TVS device 1041 and the cathode region 148 of the third TVS device 1043. Thus, the resistive path from node 201 to node 202 is via the first and second resistors 1061, 1062.

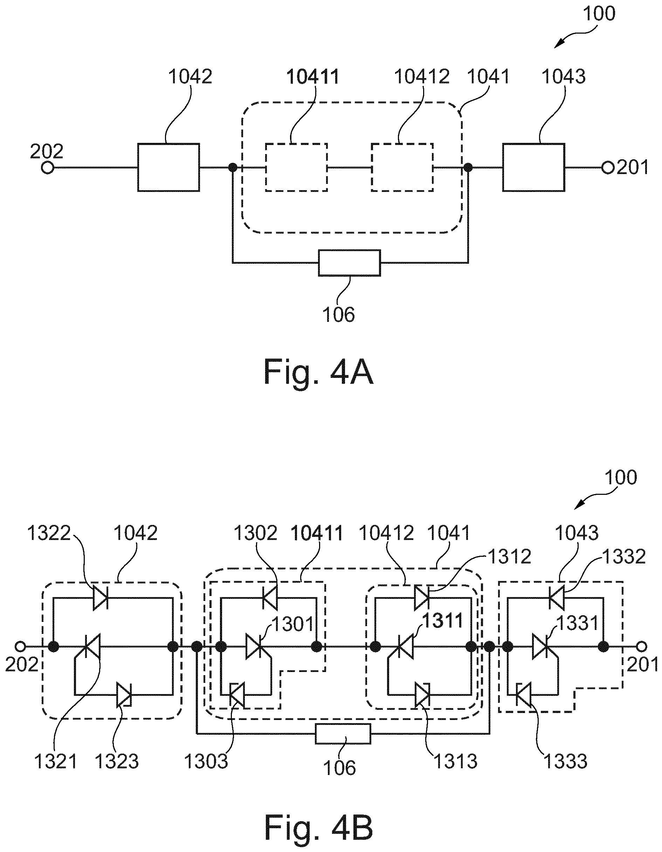

Fig. 4A illustrates a simplified circuit diagram depicting another exemplary circuit configuration of a TVS circuit 100. The first TVS device 1041 is based on a plurality of interconnected protection elements. In the illustrated example, the first TVS device 1041 includes a first sub-device 10411 and a second sub-device 10412. The resistor 106 is electrically connected in parallel to the first TVS device 1041. The second TVS device 1042 and the third TVS device 1043 are electrically connected in series to the first TVS device 1041.

The simplified circuit diagram of Fig. 4B is based on the TVS circuit of Fig. 4A and illustrates one configuration example for the first to third TVS devices 1041, 1042, 1043 that is based on SCR protection elements. The first sub-device 10411 of the first TVS device 1041 includes a SCR protection element 1301 and a bypass diode 1302 electrically connected in parallel to the SCR protection element 1301. The first sub-device 10411 further includes a trigger element. The trigger element in Fig. 4B is configured as a Zener diode 1303. Other configurations may likewise be used as a trigger element for the SCR. Similar to the first sub-device 10411, the second sub-device 10412 includes a SCR protection element 1311, a bypass diode 1312 and a Zener diode 1313. Also the second TVS device 1042 includes a SCR protection element 1321, a bypass diode 1322, and a Zener diode 1323. Likewise, the third TVS device 1043 includes a SCR protection element 1331, a bypass diode 1332, and a Zener diode 1333. Along the connection line from the second node 202 to the first node 201, the second TVS device 1042, first sub-device 10411 of the first TVS device 1041, the second sub-device 10412 of the first TVS device 1041, and the third sub-device 1043 are anti-serially connected in pairs. The specific configuration illustrated in Fig. 4B is just an example and may be varied in many ways, e.g. by using different protection elements in the TVS devices or sub-devices, or by using different voltage classes for the protection elements, or by adding further pairs of anti-serially connected TVS devices.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transient voltage suppressor, TVS, circuit (100), comprising:
a semiconductor substrate (102) comprising a first TVS device (1041) and a second TVS device (1042) electrically connected in series; and
a resistor (106), wherein the resistor (106) and at least one of the first TVS device (1042) or the second TVS device (1043) are electrically connected in parallel.

2. The TVS circuit (100) of the preceding claim, wherein the TVS circuit (100) is a discrete device.

3. The TVS circuit (100) of any of the preceding claims, wherein the semiconductor substrate (102) comprises the resistor (106).

4. The TVS circuit (100) of the preceding claim, wherein the resistor (106) is a resistive current path formed by a continuously p-doped or n-doped part of the semiconductor substrate (102).

5. The TVS circuit (100) of the preceding claim, wherein the resistive current path includes a part of the semiconductor substrate in an active area of the at least one of the first TVS device (1041) or the second TVS device (1042).

6. The TVS circuit (100) of any of the preceding claims, wherein the semiconductor substrate (102) further comprises a third TVS device (1043) and a fourth TVS device (1044) electrically connected in series, and a second resistor (1062), wherein the second resistor (1062) and at least one of the third TVS device (1043) or the fourth TVS device (1044) are electrically connected in parallel.

7. The TVS circuit (100) of the preceding claim, wherein cross-section designs of the first TVS device (1041) and the third TVS device (1043) correspond to each other.

8. The TVS circuit (100) of any of the preceding claims, wherein the first TVS device (1041) comprises a first TVS pn- or pin-diode, or a first npn- or pnp-based TVS protection element, or a first TVS SCR, and the second TVS device (1042) comprises a second TVS pnor pin-diode, or a second npn- or pnp-based TVS protection element, or a second TVS SCR, and an n-doped region (108) of the first TVS device (1041) and a p-doped region (109) of the second TVS device (1042) are electrically connected via a wiring area (110) over the semiconductor substrate (102), and the resistor (106) is a resistive current path through a p-doped part of the semiconductor substrate (102) between a p-doped region (112) of the first TVS device (1041) and the p-doped region (109) of the second TVS device (1042).

9. The TVS circuit (100) of the preceding claim, wherein the third TVS device (1043) comprises a third TVS pn- or pin-diode, or a third npn- or pnp-based TVS protection element, or a third TVS SCR, and the fourth TVS device (1044) comprises a fourth TVS pn- or pin-diode, or a fourth npn- or pnp-based TVS protection, or a fourth TVS SCR, and an n-doped region (148) of the third TVS device and a p-doped region (149) of the fourth TVS device are electrically connected via a wiring area (110) over the semiconductor substrate (102), and the second resistor (1062) is a resistive current path through a p-doped part of the semiconductor substrate (102) between a p-doped region (152) of the third TVS device and the p-doped region (149) of the fourth TVS device.

10. The TVS circuit (100) of the preceding claim, further comprising a third resistor (1063) being a resistive current path through a p-doped part of the semiconductor substrate (102) between the p-doped region (112) of the first TVS device and the p-doped region (152) of the third TVS device.

11. The TVS circuit (100) of any of claims 1 to 7, wherein the first TVS device (1041) comprises a first TVS pn- or pin-diode, or a first npn- or pnp-based TVS protection element, or a first TVS SCR, and the second TVS device (1042) comprises a second TVS pn- or pin-diode, or a second npn- or pnp-based TVS protection element, or a second TVS SCR, and a p-doped region (112) of the first TVS device and an n-doped region (114) of the second TVS device are electrically connected via a wiring area (110) over the semiconductor substrate (102), and the resistor (106) is a resistive current path through an n-doped part of the semiconductor substrate (102) between an n-doped region (108) of the first TVS device and the n-doped region (114) of the second TVS device.

12. The TVS circuit (100) of the preceding claim, wherein the third TVS device (1043) comprises a third TVS pn- or pin-diode, or a third npn- or pnp-based TVS protection element, or a third TVS SCR, and the fourth TVS device (1044) comprises a fourth TVS pn- or pin-diode, or a fourth npn- or pnp-based TVS protection element, or a fourth TVS SCR, and a p-doped region (152) of the third TVS device and an n-doped region (154) of the fourth TVS device are electrically connected via a wiring area (110) over the semiconductor substrate (102), and the second resistor (1062) is a resistive current path through an n-doped part of the semiconductor substrate (102) between an n-doped region (148) of the third TVS device and the n-doped region (154) of the fourth TVS device.

13. The TVS circuit (100) of the preceding claim, further comprising a third resistor (1063) being a resistive current path through an n-doped part of the semiconductor substrate (102) between the n-doped region (108) of the first TVS device and the n-doped region (148) of the third TVS device.

14. A method of manufacturing a transient voltage suppressor, TVS, circuit (100), the method comprising:
forming a first TVS device (1041) and a second TVS device (1042) in a semiconductor substrate (102), and electrically connecting the first TVS device (1041) and the second TVS device (1042) in series;
providing a resistor (106), wherein the resistor (106) and at least one of the first TVS device (1042) or the second TVS device (1043) are electrically connected in parallel.

15. The method of claim 14, wherein the resistor (106) is provided as a resistive current path formed by a continuously p-doped or n-doped part of the semiconductor substrate (102).
